Europäisches Patentamt

European Patent Office

Office européen des brevets

(11) Veröffentlichungsnummer: **0 469 187 A1**

## EUROPÄISCHE PATENTANMELDUNG

(21) Anmeldenummer: **90123228.0**

(22) Anmeldetag: **04.12.90**

(51) Int. Cl.5: **H05K 7/20**

(30) Priorität: **30.07.90 DE 9011203 U**

(43) Veröffentlichungstag der Anmeldung:
**05.02.92 Patentblatt 92/06**

(84) Benannte Vertragsstaaten:
**BE DE FR GB**

(71) Anmelder: **SIEMENS AKTIENGESELLSCHAFT
Wittelsbacherplatz 2
W-8000 München 2(DE)**

(72) Erfinder: **Betzler, Hans Ludwig, Dipl.-Ing. (FH)
Allgäuerstrasse 57
W-8000 München 71(DE)**
Erfinder: **Ouerengässer, Manfred
Nockherstrasse 36a
W-8000 München 90(DE)**

(54) **Kühlanordnung für ein Leiterplattenpaket.**

(57) Zur Kühlung eines in einem Gehäuse (21) angeordneten Leiterplattenpaketes (20) sind am Gehäuseboden (24) ein Lüfter (33) und eine Lufteintrittsöffnung (35) vorgesehen. Die Kühlluft wird über Luftlenkelemente (10,15,18) durch das ganze Leiterplattenpaket gelenkt und zu einer einzigen, mit Luftaustrittsöffnungen (36) versehenen Gehäuseseitenwand (27) geführt. Auf diese Weise werden ein Kühlluftstrom mit definierter Verteilung und Führung der Kühlluft erzwungen und Temperaturherde in stark erwärmten Leiterplattenzonen verhindert. Die Erfindung ist für Leiterplattenpakete geeignet.

FIG 10

Die Erfindung betrifft eine Kühlanordnung für ein in einer Aufnahme angeordnetes Leiterplattenpaket.

Elektrische Geräte, insbesondere der Nachrichtentechnik, enthalten häufig Baugruppen, die aus mehreren wie ein Paket in verschiedenen Ebenen parallel übereinander angeordneten Leiterplatten bestehen. Da Baugruppen in elektrischen Geräten häufig mechanisch getrennt und elektrisch abgeschirmt von anderen Baugruppen untergebracht werden müssen, verwendet man in diesen Fällen wannenartige Metallgehäuse zur Aufnahme und Abschirmung der Baugruppen. Bei solchen in einer Aufnahme angeordneten Baugruppen entsteht beim Betrieb des Gerätes, z.B. im Sendebetrieb eines Leistungsverstärkers, erhöhte Verlustwärme in den Bauelementezonen. Dadurch bilden sich einzelne Temperaturherde oder Wärmenester, die so entwärmt werden müssen, daß der Gerätebetrieb über den gesamten Temperatur-Einsatzbereich aufrecht erhalten werden kann.

Der Erfindung liegt daher die Aufgabe zugrunde, eine Kühlanordnung für ein in einer Aufnahme angeordnetes Leiterplattenpaket zu schaffen, die eine Entstehung von Wärmenestern verhindert, eine wirkungsvolle Kühlung des Leiterplattenpaketes ermöglicht und somit einen dauerhaften Gerätebetrieb gewährleistet.

Diese Aufgabe wird bei einer Kühlanordnung gemäß der Erfindung dadurch gelöst, daß an der Außenseite der Aufnahme ein Axiallüfter angeordnet und die betreffende Seitenwand der Aufnahme mit einer Lufteintrittsöffnung ausgebildet ist, daß auf den Leiterplatten mehrere Luftlenkelemente vorgesehen und derart angeordnet und ausgebildet sind, daß die in das Leiterplattenpaket einströmende Kühlluft durch das ganze Leiterplattenpaket hindurch und insbesondere in Leiterplattenzonen mit hoher Verlustwärme gelenkt und zu einer einzigen weiteren Seitenwand der Aufnahme hingeführt wird, und daß diese Seitenwand der Aufnahme mit über die gesamte Fläche der Seitenwand verteilt angeordneten Luftaustrittsöffnungen versehen ist.

Bei einer derartigen Kühlanordnung wird ein verbessertes Temperaturverhalten der gesamten Baugruppe dadurch erzielt, daß das in der Aufnahme angeordnete Leiterplattenpaket mittels eines außen angebauten Axiallüfters von einem erzwungenen Luftstrom durchströmt wird. Dabei wird durch die bei einer erfindungsgemäßen Kühlanordnung vorgesehenen Maßnahmen eine definierte Verteilung und Führung der Kühlluft innerhalb eines Leiterplattenpaketes erreicht, so daß eine Entstehung von Wärmenestern bzw. unzulässige Temperaturerhöhungen an den verschiedenen Bauelementen verhindert und ein dauerhafter Gerätebetrieb gewährleistet werden.

Bei elektrischen Baugruppen wird insbesondere durch fast plan auf der Leiterplatte aufliegende elektrische Bauelemente, wie z.B. Ringkernspulen, eine besonders starke Verlustwärme erzeugt. Diese Bauelemente erwärmen sich dann zum Teil sehr stark, insbesondere im Bereich des Innendurchmessers, der keinen Luftdurchsatz ermöglicht. Es ist daher vorteilhaft, wenn die Leiterplatten in Bauelementezonen mit besonders hoher Verlustwärme derart mit mehreren, als Luftlenkelemente dienenden Bohrungen versehen sind, daß die Bauelemente gleichmäßig vom Luftstrom umspült werden. Auf diese Weise kann bei solchen Bauelementen ein Wärmestau wirkungsvoll und in einfacher Weise verhindert werden, wobei die Bohrungen in kostengünstiger und einfach zu handhabender Weise zugleich zur Befestigung der Bauelemente auf der Leiterplatte verwendet werden können.

Besonders zweckmäßig ist es, wenn zur elektrischen Abschirmung verschiedener Leiterplattenbereiche gegeneinander vorgesehene Trennwände als Luftlenkelemente dienen und so gelocht sind, daß die elektrische Schirmwirkung einerseits und der Luftdurchsatz andererseits gewährleistet sind. Dadurch erfüllen die Trennwände in vorteilhafter Weise eine Doppelfunktion.

Im Hinblick auf eine noch bessere Wärmeverteilung ist es vorteilhaft, wenn an einer Seite des Leiterplattenpakets ein den betreffenden Baugruppenraum dicht abschließender Deckel vorgesehen und zur zusätzlichen Wärmeentzerrung mit wärmeerzeugende Bauelemente tragenden Winkelblechen verbunden ist.

Weitere vorteilhafte Ausgestaltungen des Gegenstandes des Anspruchs 1 sind in den übrigen Unteransprüchen angegeben.

Ein Ausführungsbeispiel einer erfindungsgemäßen Kühlanordnung ist im folgenden anhand der Zeichnung näher beschrieben. Es zeigen

Fig. 1 eine aus einem Leiterplattenpaket bestehende elektrische Baugruppe in explosionsartiger Darstellung,

Fig. 2,3 und 4 die vollständig montierte Baugruppe in drei Ansichten,

Fig. 5,6 und 7 eine Aufnahme für das Leiterplattenpaket in drei Ansichten,

Fig. 8,9 und 10 die komplette Baugruppe mit Kühlanordnung in drei Ansichten und

Fig. 11 einen Schnitt XI-XI nach Fig. 10.

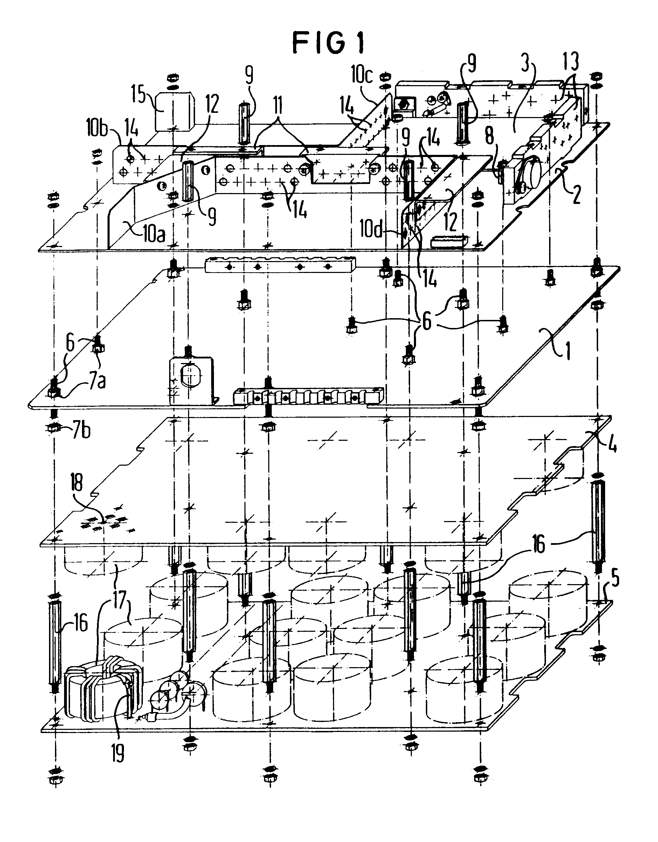

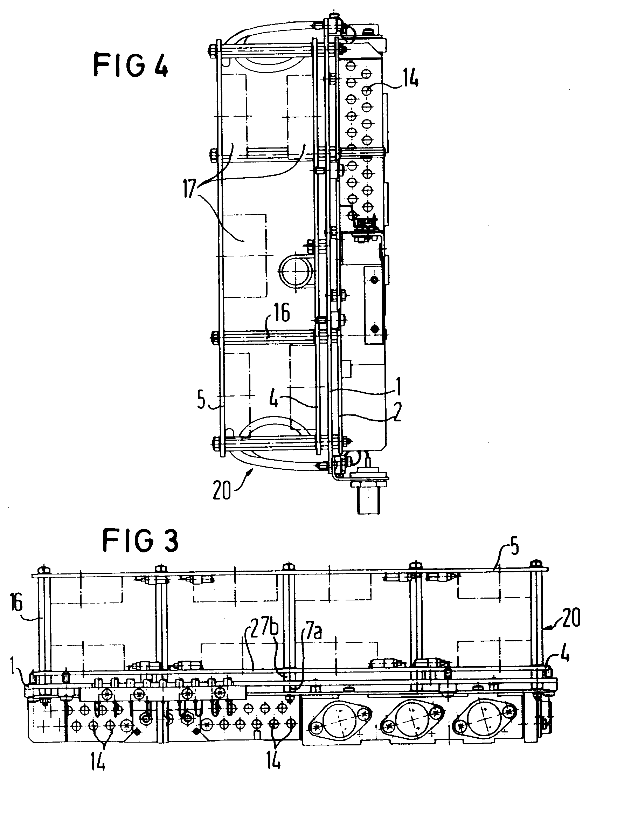

Die elektrische Baugruppe nach den Figuren 1 bis 4 stellt ein sogenanntes Oberwellenfilter eines 1 kW-Kurzwellen-Leistungsverstärkers dar, das im Sendebetrieb die Abstrahlung von Oberwellen begrenzt. Die Baugruppe besteht aus mehreren Leiterplatten, die wie ein Paket in verschiedenen Ebenen übereinander angeordnet sind. Der Träger des Leiterplattenpaketes ist eine metallene Grundplatte 1, die zwischen zwei oberen Leiterplatten 2 und 3 und zwei unteren Leiterplatten 4 und 5 angeordnet ist. Damit ist die Baugruppe räumlich und HFmäßig in einen oberen und in einen unteren Baugruppenraum getrennt, d.h. die auf den unteren Leiterplatten 4 und 5 untergebrachten Filterbereiche mit Ringkernspulen und Kondensatoren sind von dem auf den oberen Leiterplatten 2 und 3 vorgesehenen Steuerungsteil mit Relaisschaltungen, Dioden und Transistoren mechanisch getrennt und elektrisch gegeneinander abgeschirmt. Die Leiterplatten 2,4 und 5 haben die gleichen Außenabmessungen und weisen - wie auch die mit einer Teilbaugruppe ausgebildete, wesentlich kleinere und auf der oberen Leiterplatte 2 montierte zusätzliche Leiterplatte 3 - das gleiche Befestigungsbohrbild wie die Grundplatte 1 auf. Die Grundplatte ist mit mehreren, mit Gewinden versehenen Abstandsbolzen 6 versehen, die sowohl in den oberen als auch in den unteren Baugruppenraum hineinragen und mit an der Ober- und an der Unterseite vorgesehenen Sechskantelementen 7a und 7b an der Grundplatte befestigt sind. An diesen Abstandsbolzen 6 sind die oberen Leiterplatten 2 und 3 und die unteren Leiterplatten 4 und 5 befestigt, wobei die Sechskantelemente 7a und 7b durch eine entsprechende Bemessung gleichzeitig als Abstandselemente zwischen der Grundplatte 1 und der ihr jeweils am nächsten liegenden oberen Leiterplatte 2 bzw. der unteren Leiterplatte 4 dienen.

Auf der Oberseite der Grundplatte 1 wird die Leiterplatte 2 mit der zu ihr über Abstandselemente 8 beabstandeten zusätzlichen Leiterplatte 3 montiert. Die obere Leiterplatte 2 weist zur Befestigung eines Deckels 39 vier säulenartige Abstandsbolzen 9 auf und ist elektrisch in verschiedene Bereiche unterteilt. Zur Abschirmung dieser Bereiche gegeneinander sind unterschiedlich ausgeformte metallene Trennwände 10a, 10b, 10c und 10d in die Leiterplatte 2 eingeschwallt, an denen Winkelbleche 11 mit wärmeerzeugenden Bauelementen, z.B. mit Dioden, und als Griffe ausgeformte Winkelbleche 12 zur Handhabung der ganzen Baugruppe montiert sind (Fig. 1 bis 4).

Außerdem weist die obere Leiterplatte 2 noch zwei vorgefertigte Teilbaugruppen mit z.B. aus Aluminium bestehenden Klötzen 13 und daran befestigten Transistoren auf. Die Trennwände 10a,10b, 10c und 10d dienen gleichzeitig als Luftlenkelemente und sind - wie in den Figuren 1,3 und 4 zu sehen ist - gelocht, wobei die Lochungen 14 so vorgenommen sind, daß einerseits die elektrische Schirmwirkung und andererseits ein ausreichender Luftdurchsatz gewährleistet sind. Außerdem ist die obere Leiterplatte 2 noch in einem Randbereich an der linken oberen Ecke mit einem weiteren Luftleitblech 15 versehen.

Auf der Unterseite der Grundplatte 1 werden die beiden Leiterplatten 4 und 5 des Filterbereiches mit Abstandselementen 16 an den Abstandsbolzen 6 der Grundplatte montiert, wobei die beiden Leiterplatten 4 und 5 mit ihren Bauelementeseiten einander zugewandt sind. Diese Leiterplatten tragen u.a. Ringkernspulen 17, die fast plan aufliegen und starke Verlustwärme erzeugen. Diese Bauelemente erwärmen sich zum Teil sehr stark, insbesondere im Bereich des Innendurchmessers, der keinen Luftdurchsatz ermöglicht. Aus diesem Grund sind die Leiterplatten 4 und 5 in diesen Bauelementezonen mit mehreren als Luftlenkelemente dienenden Bohrungen 18 versehen. Hier ist die Anordnung dieser Bohrungen so getroffen, daß im Bereich des Innendurchmessers der Ringkernspulen 17 eine Zentralbohrung vorgesehen ist, während die übrigen Bohrungen im Außenbereich um die Ringkernspulen herum angeordnet sind, so daß diese Bauelemente gleichmäßig von einem Kühlluftstrom umspült werden können. Die Bohrungen 18 können außerdem gleichzeitig zur Befestigung der Ringkernspulen 17 mittels Kabelbinder 19 verwendet werden.

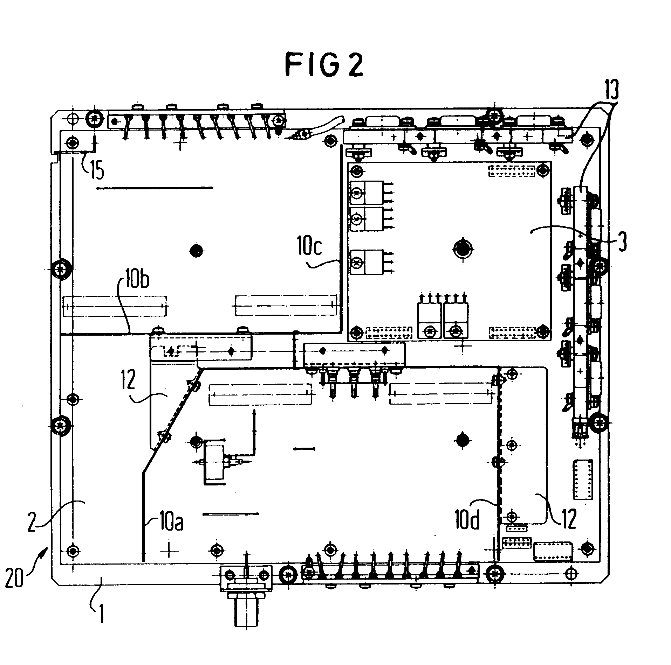

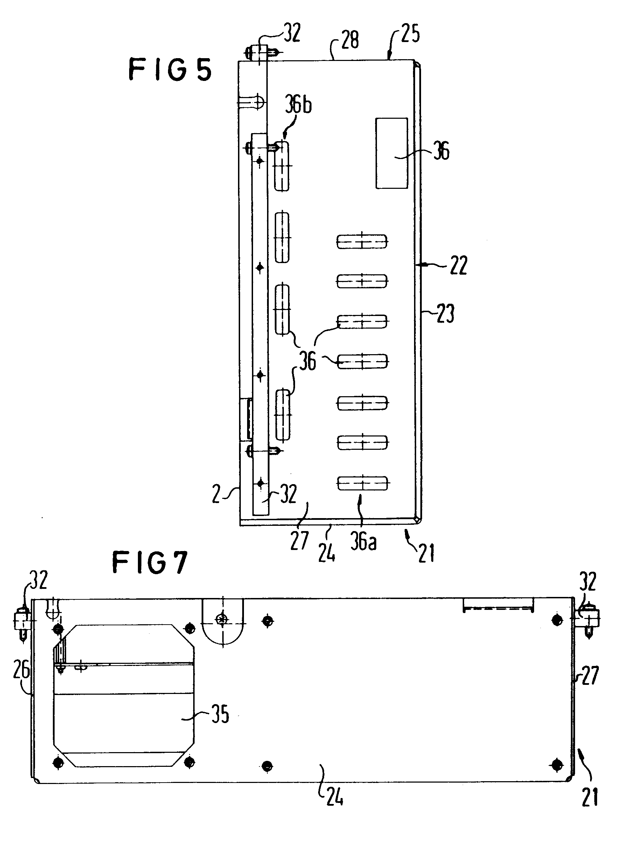

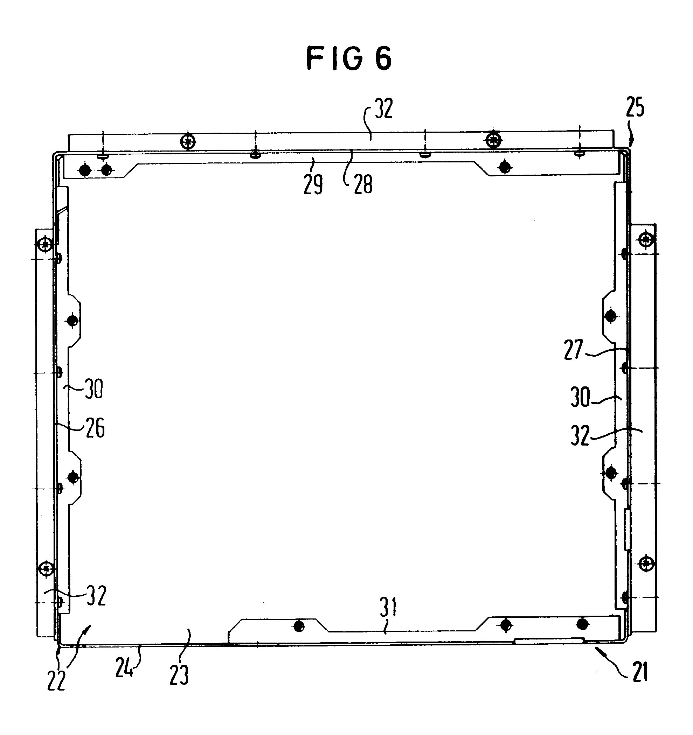

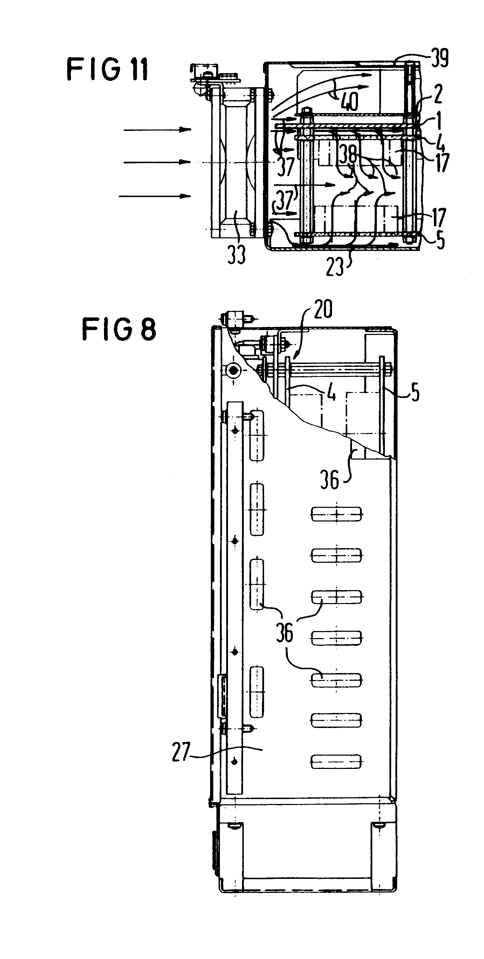

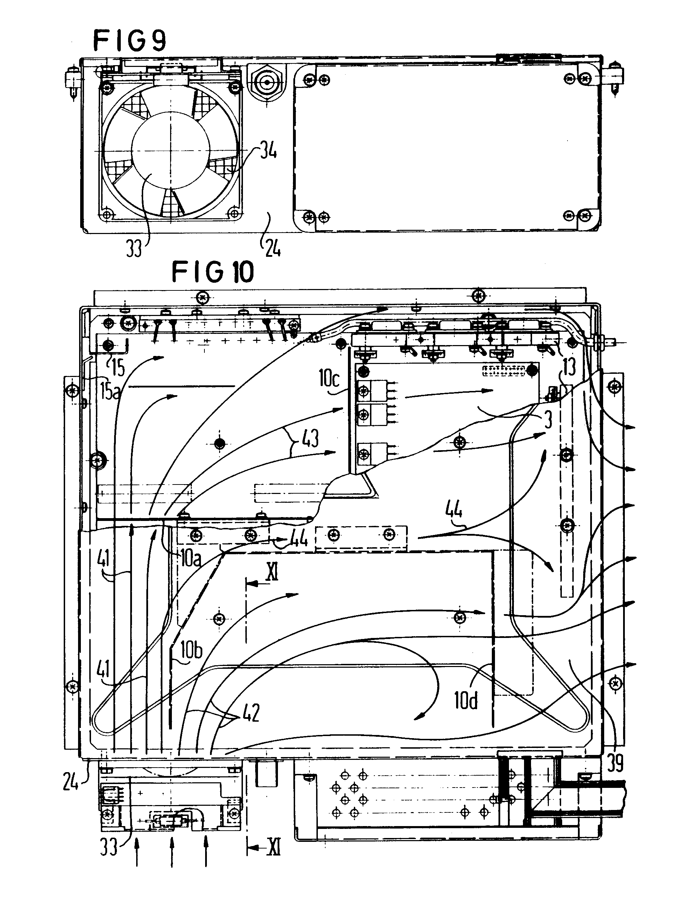

Das in den Figuren 2 bis 4 dargestellte Leiterplattenpaket stellt eine kompakte, elektrisch verdrahtete und prüfbare Baugruppe 20 dar, welche in einer in den Figuren 5 bis 7 gezeigten Aufnahme untergebracht wird. Diese Aufnahme besteht aus einem im Querschnitt U-förmigen, wannenartig ausgebildeten Gehäuse 21 aus einer punktgeschweißten Blechkonstruktion, die aus einem L-förmigen Blechteil 22 und einem U-förmigen Blechteil 25 zusammengesetzt ist, wobei das L-förmige Blechteil 22 die Gehäuserückwand 23 und den Gehäuseboden 24 und das U-förmige Blechteil 25 die übrigen drei Gehäuseseitenwände 26,27 und 28 bildet. Zur Aufnahme der elektrischen Baugruppe 20 ist auf der Innenfläche der Gehäuseseitenwände 23,26,27 und 28 auf gleicher Höhe jeweils ein aus Blech bestehender, mit Gewindeeinpreßmuttern ausgebildeter Auflagewinkel 29,30 und 31 angepunktet, an dem die Grundplatte 1 des Leiterplattenpaketes schraubbar befestigt ist (Fig.8,10). Zur Halterung der Aufnahme selbst in einem Gerät sind an der oberen Gehäuseseitenwand 28 und den beiden seitlichen Gehäusewänden 26,27, also an dem U-förmigen Blechteil 25, mit unverlierbaren Schrauben ausgebildete Schienen 32 auf gleicher Höhe angeordnet und an den Gehäuseseitenwänden festgeschraubt.

Zur Kühlung des in der Aufnahme montierten Leiterplattenpaketes ist an der Außenseite des die Aufnahme bildenden Gehäuses 21, hier links unten an dem Gehäuseboden 24, ein Axiallüfter 33 angeordnet, wobei der Gehäuseboden mit einer gemäß den Größenvorgaben des Lüfterherstellers bemessenen, mit einem HF-Gitter 34 abgedeckten Lufteintrittsöffnung 35 (Fig.7) ausgebildet ist. Die Luftaustrittsöffnungen 36 (Fig.8) befinden sich nur auf der rechten Seite der Aufnahme, sind langlochartig ausgebildet und in einer Gruppe 36a zueinander parallel sowie in einer hierzu senkrechten Gruppe 36b in Reihe untereinander oder hintereinander liegend über die gesamte Fläche der rechten Gehäuseseitenwand 27 verteilt angeordnet (Fig.5). Der Luftstrom hat sich also von links unten nach rechts außen zu bewegen, wobei sich die eintretende Luftmenge entsprechend der Höhe, in der die Grundplatte 1 des Leiterplattenpaketes angeordnet ist, verteilt. Im dargestellten Ausführungbeispiel erfolgt die Verteilung der Luftmenge zu ca. ein Drittel im oberen Baugruppenraum mit den Leiterplatten 2 und 3 und zu ca. zwei Drittel im unteren Baugruppenraum mit den Leiterplatten 4 und 5 (Fig. 11). Im unteren Bereich der Aufnahme bläst der Axiallüfter 33 die angesaugte Luft - wie in Fig.11 durch Pfeile 37 kenntlich gemacht - sowohl in den unteren Baugruppenraum mit den Leiterplatten 4 und 5 als auch in die Zwischenräume zwischen der Grundplatte 1 und den Leiterplatten 2 bzw. 4 sowie zwischen der Leiterplatte 5 und der Gehäuserückwand 23. Dabei werden die elektrischen Bauelemente, wie z.B. die Ringkernspulen 17, infolge der Ausbildung der Leiterplatten 4 und 5 mit Bohrungen 18 gleichmäßig vom Luftstrom umspült. Dies ist ebenfalls in Fig.11 durch Pfeile 38 verdeutlicht. Der obere Baugruppenraum, in dem sich die Leiterplatte 2 befindet, ist durch gezielte Luftlenkungsmaßnahmen wärmetechnisch verbessert. Die im oberen Drittel der Baugruppe vom Axiallüfter 33 in den oberen Baugruppenraum austretende Luft strömt zu einem kleinen Teil zwischen Grundplatte 1 und Leiterplatte 2, die Hauptmenge der Kühlluft gelangt jedoch in den Baugruppenraum zwischen der Leiterplatte 2 und dem Deckel 39 der Aufnahme, was durch Pfeile 40 in Fig.11 kenntlich gemacht ist. Die vordere Trennwand 10b (Fig.10) im Luftaustrittsbereich des Axiallüfters 33 teilt die ausgeblasene Luftmenge nochmals (Pfeile 41 bzw. 42) und kühlt den entsprechenden, rechts von der Trennwand 10b liegenden Bereich (Pfeile 42). Die restliche Luftmenge strömt geradeaus (Pfeile 41), zum Teil links an der Trennwand 10a vorbei bis zu dem Leitblech 15 der Grundplatte 1 bzw. dem Leitblech 15a der Aufnahme in den hinter der Trennwand 10a liegenden Bauelementebereich und zur Trennwand 10c (Pfeile 43), der Rest der Luftmenge prallt auf die teildurchlässige querstehende Trennwand 10a und strömt in den Kanal zwischen den beiden Trennwänden 10a und 10b hindurch (Pfeile 44). In den Außenbereichen der Leiterplatte 2 werden die stehenden Klötze 13 mit den daran befestigten Transistoren von Luft umspült. Die auf Abstand zur Leiterplatte 2 angeordnete zusätzliche Leiterplatte 3 wird sowohl auf der Oberseite als auch auf der Unterseite von Luft umströmt, was bei Ausbildung als beidseitig beschichtete SMD-Leiterplatte von besonderem Vorteil ist. Der Luftstrom tritt an der rechten Seite der Aufnahme über die Luftaustrittsöffnungen 36 aus und kann gegebenenfalls zur weiteren gezielten Belüftung von Baugruppen in einem Gerät benutzt werden. Dabei entsteht, sofern das Gerät geschlossen ist, eine staubfreie Luftumwälzung im Gerät. Für den Fall, daß ein Außenluftkreis für die gezielte Entwärmung sorgt, ist auf Filterung der Luft zu achten, damit Ablagerungen auf den Bauelementen die Lebensdauer des Gerätes nicht durch steigende Temperaturen verkürzen oder einen Austausch oder Service der Baugruppen erfordern.

Die beschriebene Belüftung der kompakt aufgebauten, in der Aufnahme montierten Baugruppe mit gezielter Luftführung - zusätzlich unterstützt z.B. durch die Anordnung von Teilbaugruppen und die Ausformung von Leiterplatten - verhindern eine Entstehung von Wärmenestern bzw. unzulässigen Temperaturerhöhungen an den verschiedenen Bauelementen und sorgen somit für dauerhaften Geräteeinsatz im Sendebetrieb.

Eine zusätzliche Wärmeentzerrung wird bei der in Fig.10 dargestellten Baugruppe mit Kühlanordnung noch dadurch erreicht, daß der an einer Seite des Leiterplattenpaketes vorgesehene, den oberen Baugruppenraum dicht abschließende Deckel 39 mit den die wärmeerzeugenden Bauelemente tragenden Winkelblechen 11 und den Klötzen 13 verschraubt ist.

**Patentansprüche**

1.  Kühlanordnung für ein in einer Aufnahme angeordnetes Leiterplattenpaket,
    **dadurch gekennzeichnet**, daß an der Außenseite der Aufnahme (21) ein Axiallüfter (33) angeordnet und die betreffende Seitenwand (24) der Aufnahme mit einer Lufteintrittsöffnung (35) ausgebildet ist,
    daß auf den Leiterplatten (2,3,4,5) mehrere Luftlenkelemente (10,15,18) vorgesehen und derart angeordnet und ausgebildet sind, daß die in das Leiterplattenpaket einströmende Kühlluft durch das ganze Leiterplattenpaket hindurch und insbesondere in Leiterplattenzonen mit hoher Verlustwärme gelenkt und zu einer einzigen, weiteren Seitenwand (27) der Aufnahme (21) hingeführt wird, und
    daß diese Seitenwand der Aufnahme mit über die gesamte Fläche der Seitenwand verteilt angeordneten Luftaustrittsöffnungen (36) versehen ist.

2.  Kühlanordnung nach Anspruch 1,
    **dadurch gekennzeichnet**, daß die Leiterplatten (4,5) in Bauelementezonen mit besonders hoher Verlustwärme derart mit mehreren als Luftlenkelemente dienenden Bohrungen (18) versehen sind, daß die Bauelemente (17) gleichmäßig vom Luftstrom umspült werden.

3. Kühlanordnung nach Anspruch 2,
   **dadurch gekennzeichnet**, daß die Bauelemente (17) mit Hilfe von Kabelbindern (19) in den Bohrungen (18) der Leiterplatten (4,5) gehalten sind.

4. Kühlanordnung nach einem der Ansprüche 1 bis 3,
   **dadurch gekennzeichnet**, daß zur elektrischen Abschirmung verschiedener Leiterplattenbereiche gegeneinander vorgesehene Trennwände (10a,10b,10c,10d) als Luftlenkelemente dienen und so gelocht sind, daß die elektrische Schirmwirkung einerseits und der Luftdurchsatz andererseits gewährleistet sind.

5. Kühlanordnung nach einem der vorhergehenden Ansprüche,
   **dadurch gekennzeichnet**, daß insbesondere in den Leiterplattenrandbereichen zusätzliche Luftleitbleche (15) angeordnet sind.

6. Kühlanordnung nach einem der vorhergehenden Ansprüche,
   **dadurch gekennzeichnet**, daß die Luftaustrittsöffnungen (36) langlochartig ausgebildet und in Gruppen (36a bzw. 36b) zueinander parallel und/oder in Reihe untereinander oder hintereinander angeordnet sind.

7. Kühlanordnung nach einem der vorhergehenden Ansprüche,
   **dadurch gekennzeichnet**, daß der Axiallüfter (33) vor einem HF-Gitter (34) montiert ist.

8. Kühlanordnung nach einem der vorhergehenden Ansprüche,
   **dadurch gekennzeichnet**, daß an einer Seite des Leiterplattenpakets ein den betreffenden Baugruppenraum dicht abschließender Deckel (39) vorgesehen und zur zusätzlichen Wärmeentzerrung mit wärmeerzeugende Bauelemente tragenden Winkelblechen (11) und Klötzen (13) verbunden ist.

# FIG 1

# FIG 2

FIG 4

FIG 3

FIG 5

FIG 7

# FIG 6

FIG 11

FIG 8

# FIG 9

34

33  24

# FIG 10

15

15a

10c

43

13

3

44

44

41

10a

XI

10b

41

42

10d

24

39

33

XI

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-3 956 673   (SEID G.) <br> – – – | 1 | H 05 K 7/20 |
| A | IBM TECHNICAL DISCLOSURE BULLETIN. Bd. 32, Nr. 6B, November 1989, NEW YORK US Seiten 417 - 419; 'open-loop cooling system for computers in a hostile environment' <br> * das ganze Dokument * * <br> – – – | 1 | |
| A | US-A-4 837 663   (ZUSHI ET AL.) <br> * Spalte 3, Zeile 11 - Zeile 22; Abbildung 1 * * <br> – – – | 1 | |
| A | IEEE ELECTRO Bd. 7, Mai 1982, NEW YORK US Seiten 1 - 7; JOHN BARTOSZEK: 'cabinet design and flow distribution systems' <br> – – – – – | 1 | |

RECHERCHIERTE SACHGEBIETE (Int. Cl.5)

H 05 K

Der vorliegende Recherchenbericht wurde für alle Patentansprüche erstellt

| Recherchenort | Abschlußdatum der Recherche | Prüfer |
|---|---|---|
| Den Haag | 27 November 91 | RUBENOWITZ A.S. |